# EUROPEAN PATENT SPECIFICATION

(11) **EP 2 793 316 B1**
(45) Date of publication and mention of the grant of the patent: **03.01.2018**
(21) Application number: 14162630.9
(22) Date of filing: 31.03.2014
(51) Int. Cl.: H01R 13/447, H01R 13/52, H05K 5/02

(54) **USB pen device with clamping means to secure its cap**
USB-Gerät mit Spannmittel
Dispositif USB avec des moyens de serrage pour fixer son cap

(30) Priority: 19.04.2013 CN 201310138029
(43) Date of publication of application: 22.10.2014
(73) Proprietor: Huawei Device Co., Ltd., Longgang District Shenzhen Guangdong 518129 (CN)
(72) Inventor: Guo, Genghui, 518129 Shenzhen (CN); Xiao, Jianjun, 518129 Shenzhen (CN); Zhao, Menglong, 518129 Shenzhen (CN)
(74) Representative: Goddar, Heinz J.

(56) References cited:
- CN-A- 1 698 064
- JP-A- 2003 282 178
- US-A1- 2003 137 859
- US-A1- 2006 211 279
- US-B1- 7 503 780
- US-B1- 7 686 629

## Description

### TECHNICAL FIELD

The present invention relates to electronic devices, and in particular, to a USB device.

### BACKGROUND

A universal serial bus (Universal Serial BUS, USB) is an external bus standard and is widely applied to computer peripherals and electronic devices such as a mobile phone and a digital camera. When a USB connector is in an unused state, the USB connector is easily exposed to substances such as dust and water, which may affect data reading of an electronic device and even damage the electronic device. In addition, the USB connector may be broken in a carrying process. Therefore, at present, a USB cap is arranged on portable USB devices like a USB flash drive and a wireless data card.

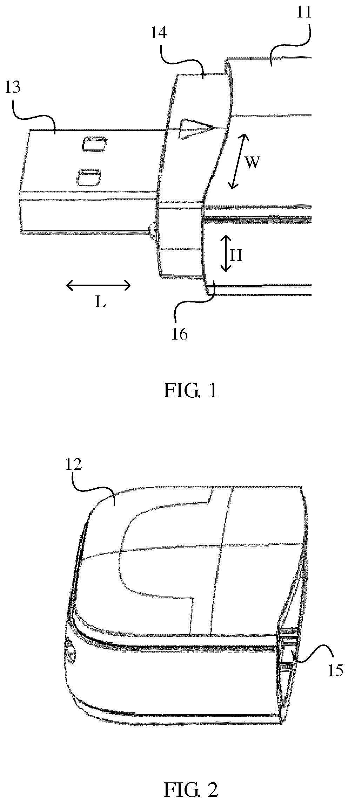

FIG. 1 is a schematic structural diagram of a main body of a USB device in the prior art. FIG. 2 is a schematic structural diagram of a USB cap of a USB device in the prior art. Referring to FIG. 1 and FIG. 2, the USB device includes a main body 11 and a USB cap 12, where the main body 11 includes an enclosure 16, a printed circuit board (Printed Circuit Board, PCB) (not shown in the figure) arranged inside the enclosure 16, and a USB connector 13 arranged at one end of the enclosure 16. A protruded lip side 14 is arranged around the USB connector 13, and a recess 15 fitting the lip side 14 is arranged inside the USB cap 12; the USB cap 12 and the main body 11 can be clamped together through the recess 15 and the lip side 14 which fit mutually. In this way, the USB cap 12 can protect the USB connector 13. Based on a light and thin design of the USB device, a size of the USB device along a direction where the USB connector is extended is designed to be the largest, which is defined as a length direction L of the USB device; a direction where a wide side of the USB connector is extended is defined as a width direction W of the USB device; and a direction where a narrow side of the USB connector is extended is defined as a thickness direction H of the USB device.

JP2003 282178A disclose a USB male connector which protrudes at one end of an apparatus body. A cap is connected with the apparatus body to cover the USB male connector. Lock claw parts are locked, and the cap is locked in the apparatus body by Lock claw parts arranged on the cap and openings formed in the part of the both sides of the USB male connector. Lock release button members are arranged at a position where a finger tip butts on them when gripping the cap with a hand.

US 2006/211279 A1 discloses a portable storage device that includes a memory device with a USB interface and a protective cap detachably mated with the USB interface. The USB interface may be a conventional one, which has a metal shell defined pair of holes therein. However, in the prior art, the fitting structure where the USB cap and the main body are clamped together through the recess and the lip side is less flexible.

CN1698064A also discloses several embodiments of USB devices with correspondent USB caps.

### SUMMARY

The present invention provides a USB device according to independent claim 1.

Further embodiments are provided according to the dependent claims 2 to 8.

By arranging a first clamping portion on an enclosure surface of a main body of a USB device on which a USB connector is arranged, and arranging a second clamping portion that fits the first clamping portion inside a USB cap, the USB cap and the main body can be fixed and connected together through the clamping between the first clamping portion and the second clamping portion and the USB connector on the main body can be covered by the USB cap, thereby providing a USB device with a flexible structure.

### BRIEF DESCRIPTION OF DRAWING(S)

To describe the technical solutions in the embodiments of the present invention or in the prior art more clearly, the following briefly introduces the accompanying drawings required for describing the embodiments or the prior art. Apparently, the accompanying drawings in the following description show some embodiments of the present invention, and persons of ordinary skill in the art may still derive other drawings from these accompanying drawings without creative efforts.
FIG. 1 is a schematic structural diagram of a main body of a USB device in the prior art.
FIG. 2 is a schematic structural diagram of a USB cap of a USB device in the prior art.

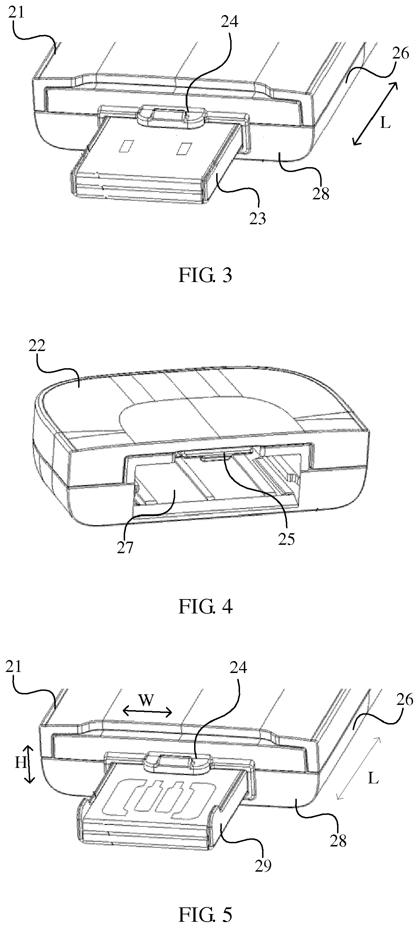

FIG. 3 is a schematic structural diagram of a main body of a USB device according to the present invention. In this figure the third clamping portion is not shown. The third clamping portion is adjacent to the lower surface of the USB connector, said lower surface being opposite to the upper surface where the first clamping portions is provided.
FIG. 4 is a schematic structural diagram of a USB cap of a USB device, and it does not fall within the scope of the present invention nor of any of its embodiments. In this figure the fourth clamping portion is not present on the lower portion of the USB cap, and thus it does not fall within the scope of claim 1.
FIG. 5 is a schematic structural diagram of another main body of a USB device according to an embodiment of the present invention.

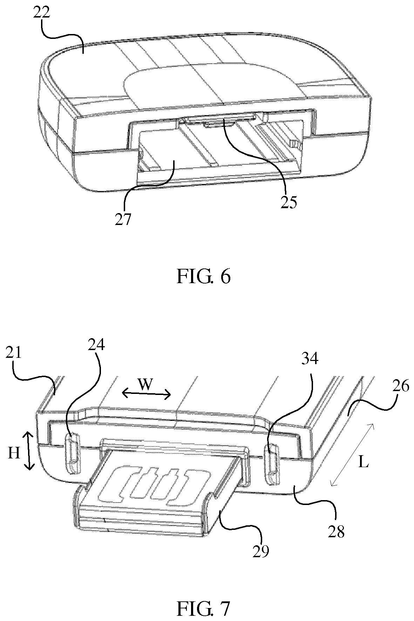

FIG. 6 is a schematic structural diagram of another USB cap of a USB device, and it does not fall within the scope of the present invention nor of any of its embodiments. In this figure the fourth clamping portion is not present on the lower portion of the USB cap, and thus it does not fall within the scope of claim 1.
FIG. 7 is a schematic structural diagram of still another main body of a USB device, and it does not fall within the scope of the present invention nor of any of its embodiments. In this figure, the first clamping portion is not visible, and thus it does not fall within the scope of claim 1.

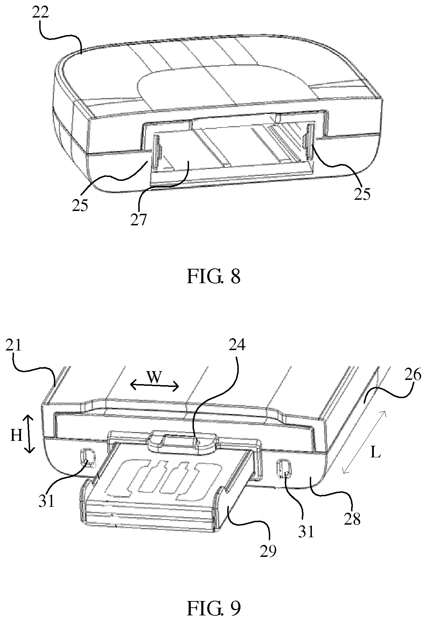

FIG. 8 is a schematic structural diagram of still another USB cap of a USB device, and it does not fall within the scope of the present invention nor of any of its embodiments. In this figure, the second and fourth clamping portions are not present, and thus this figure does not fall within the scope of claim 1.
FIG. 9 is a schematic structural diagram of yet another main body of a USB device according to an embodiment of the present invention.

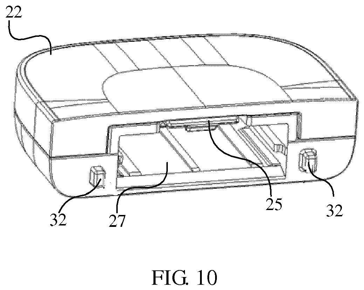

FIG. 10 is a schematic structural diagram of yet another USB cap of a USB device, and it does not fall within the scope of the present invention nor of any of its embodiments. In this figure the fourth clamping portion is not present on the lower portion of the USB cap, and thus it does not fall within the scope of claim 1.

### DESCRIPTION OF EMBODIMENTS

To make the objectives, technical solutions, and advantages of the embodiments of the present invention more clearly, the following clearly and completely describes the technical solutions in the embodiments of the present invention with reference to the accompanying drawings in the embodiments of the present invention. Apparently, the described embodiments are a part rather than all of the embodiments of the present invention.

A USB device provided by embodiments of the present invention may include but not limited to portable electronic devices that use a USB connector, such as USB flash drive and a wireless data card. When the USB device is unused, the USB connector of the USB device may be covered by a USB cap to protect the USB connector.

FIG. 3 is a schematic structural diagram of a main body of a USB device according to the present invention. FIG. 4 is a schematic structural diagram of a USB cap of a USB device. Referring to FIG. 3 and FIG. 4, the USB device includes a main body 21 and a USB cap 22.

The main body 21 includes an enclosure 26 and a PCB (not shown in the figure) arranged inside the enclosure 26. A USB connector 23 is arranged at an end portion of the main body 21 along a length direction L of the main body; a chamber 27 of the USB cap 22 is used to accommodate and protect the USB connector 23; and a first clamping portion 24 is arranged at one side of the USB connector 23 on a first enclosure surface 28 of the main body 21 on which the USB connector 23 is arranged, and a second clamping portion 25 is arranged on the USB cap 22, where the first clamping portion 24 and the second clamping portion 25 are mutually clamped so that the USB cap 22 covers the USB connector 23 and is fixed on the main body 21.

Specifically, the main body 21 of the USB device is used to implement functions that need to be implemented by the USB device. The enclosure 26 of the main body 21 includes a PCB, where devices such as a memory, a processor, and a radio transceiver are arranged on the PCB according to different types of the USB device and are used to implement such functions as storage and reception and transmission of radio signals. The enclosure 26 is used to protect devices on the PCB inside the enclosure and ensure a beautiful appearance of the USB device. The USB connector 23 is arranged on the first enclosure surface 28 of the main body 21 at one end along the length direction L of the main body, and the USB connector 23 is connected to the PCB inside the enclosure 26. When the main body 21 of the USB device is connected to a computer through the USB connector 23, the USB device can implement corresponding functions. The chamber 27 is arranged inside the USB cap 22, and a size of the chamber 27 is correspondingly set according to a size of the USB connector 23. The chamber 27 is used to accommodate and protect the USB connector 23. When the USB device is not connected to a computer, the USB connector 23 may be inserted into the chamber 27 to ensure that the USB connector 23 is not damaged. The first clamping portion 24 is further arranged at one side of the USB connector 23 on the first enclosure surface 28, and the second clamping portion 25 is further arranged on the USB cap 22, where the first clamping portion 24 and the second clamping portion 25 are matched mutually in terms of shape. In addition, the first clamping portion 24 also corresponds to the second clamping portion 25 in terms of position. In this way, when the first clamping portion 24 and the second clamping portion 25 are mutually clamped, the chamber 27 of the USB cap 22 can accommodate and protect the USB connector 23 and the USB cap 22 can be fixed on the main body 21.

It should be noted that the USB connector 23 is a rectangle and has a total of four sides. The first clamping portion 24 may be arranged at any side of the USB connector 23. The second clamping portion 25 may be arranged on an inner wall of the chamber 27 of the USB cap 22, or the second clamping portion 25 may be arranged at a side wall of the USB cap 22 that is oriented to the main body 21, or the second clamping portion 25 may be arranged on an external wall of the USB cap 22, so long as the second clamping portion 25 and the first clamping portion 24 are matched mutually in terms of shape and the first clamping portion 24 also corresponds to the second clamping portion 25 in terms of position. In this way, when the first clamping portion 24 and the second clamping portion 25 are mutually clamped, the chamber 27 of the USB cap 22 can accommodate and protect the USB connector 23 and the USB cap 22 can be fixed on the main body 21.

By arranging a first clamping portion at one side of a USB connector on an enclosure surface of a main body of a USB device on which the USB connector is arranged, and arranging a second clamping portion that fits the first clamping portion inside a USB cap, the USB cap and the main body can be fixed and connected together through the clamping between the first clamping portion and the second clamping portion and that the USB connector on the main body can be covered by the USB cap, thereby providing a USB device with a flexible structure.

FIG. 5 is a schematic structural diagram of another main body of a USB device according to an embodiment of the present invention. FIG. 6 is a schematic structural diagram of another USB cap of a USB device. Referring to FIG. 5 and FIG. 6, the USB device is different from the USB device shown in FIG. 3 and FIG. 4 only in that: A USB connector 29 is an ultra-thin USB connector, and the USB device can implement a technical solution same as that of the device shown in FIG. 3 and FIG. 4.

Hereto, the first clamping portion 24 is arranged on the first enclosure surface 28 at one end of the main body 21 along the length direction L of the main body, and the first clamping portion 24 is located at a position on the first enclosure surface 28 along a thickness direction H of the main body and close to a first surface of the USB connector 29, where the first surface is an upper surface at one side of the USB connector on which a metal fillet weld leg is deployed. In this way, the USB device provided in this embodiment only needs to arrange one clamping portion 24 in the thickness direction H to fix the USB cap 22 on the main body 21, without the need of arranging a lip side around the USB connector in the prior art. Therefore, the main body 21 of the USB device provided in this embodiment can reduce a size in a width direction W. In addition, when the thickness of the first clamping portion 24 is less than the thickness of the lip side in the prior art, the size in the thickness direction H can also be reduced. The first clamping portion 24 can be closest to the USB connector 29 as much as possible so long as the normal use of the USB connector 29 is not affected. In this way, the impact of a distance between the first clamping portion 24 and the USB connector 29 on the thickness direction H can be reduced. In addition, the first clamping portion 24 may be further arranged at a position on the first enclosure surface 28 along the thickness direction H of the main body and close to a second surface of the USB connector 29, where the second surface is a lower surface opposite to the first surface of the USB connector 29.

Further, a third clamping portion (not shown in the figure) may be further arranged on the first enclosure surface 28, where the third clamping portion and the first clamping portion 24 are arranged at different sides of the USB connector 29 on the first enclosure surface 28. For example, the first clamping portion 24 is arranged at a position on the first enclosure surface 28 along the thickness direction H of the main body and close to the first surface of the USB connector 29; the third clamping portion is arranged at a position on the first enclosure surface 28 along the thickness direction H of the main body and close to the second surface of the USB connector 29. Correspondingly, when the third clamping portion is arranged on the first enclosure surface 28, a fourth clamping portion that matches the third clamping portion in terms of both shape and position needs to be arranged on the USB cap 22. In this way, when the third clamping portion and the fourth clamping art are mutually clamped, the chamber 27 of the USB cap 22 can accommodate and protect the USB connector 23 and the USB cap 22 can be fixed on the main body 21. When the thickness of the third clamping portion is less than the thickness of the lip side in the prior art, the size in the thickness direction can also be reduced.

Further, to ensure convenience of plugging or unplugging the USB cap, the first clamping portion 24 may be arranged at a central position of the first enclosure surface 28 along the width direction W of the main body.

The second clamping portion 25 on the USB cap 22 needs to be arranged to correspond to the first clamping portion 24. If multiple first clamping portions 24 are arranged concurrently, second clamping portions 25 of a same quantity need to be arranged. In addition, when the USB cap 22 covers the main body 21 for fixing, each of the second clamping portions 25 needs to be clamped correspondingly with each of the corresponding first clamping portions 24. Similarly, the fourth clamping portion on the USB cap 22 needs to be arranged to correspond to the third clamping portion. If multiple third clamping portions are arranged concurrently, fourth clamping portions of a same quantity need to be arranged. In addition, when the USB cap 22 covers the main body 21 for fixing, each of the fourth clamping portions needs to be clamped correspondingly with each of the corresponding third clamping portions.

FIG. 7 is a schematic structural diagram of still another main body of a USB device, and it does not fall within the scope of the present invention nor of its embodiments. FIG. 8 is a schematic structural diagram of still another USB cap of a USB device, and it does not fall within the scope of the present invention nor of its embodiments. Referring to FIG. 7 and FIG. 8, the USB device is different from the USB device shown in FIG. 5 and FIG. 6 in that: The first clamping portion 24 is arranged on the first enclosure surface 28 at one end of the main body 21 along the length direction L of the main body; the first clamping portion 24 is located at a position on the first enclosure surface 28 along the width direction W of the main body and close to a third surface of the USB connector 29; and a third clamping portion 34 is further arranged at a position on the first enclosure surface 28 along the width direction W of the main body and close to a fourth surface of the USB connector 29, where the third surface and the fourth surface are two narrow side surfaces of the USB connector. In this way, the USB device only needs to arrange the first clamping portion 24 and the third clamping portion 34 in the width direction W to fix the USB cap 22 on the main body 21, without the need of arranging a lip side around the USB connector in the prior art. Therefore, the main body of the USB device can reduce a size in the thickness direction H.

It should be noted that the first clamping portion 24 may be further arranged only at a position on the first enclosure surface 28 along the width direction W of the main body and close to the third surface of the USB connector 29 or the first clamping portion 24 may be arranged only at a position on the first enclosure surface 28 along the width direction W of the main body and close to the fourth surface of the USB connector 29. In this way, when the thickness of the first clamping portion 24 is less than the thickness of the lip side in the prior art, the size in the width direction W can also be reduced. The third clamping portion 34 may be further arranged at a side of the USB connector 29 on the first enclosure surface 28 along the thickness direction H of the main body. When the thickness of the third clamping portion 34 is less than the thickness of the lip side in the prior art, the size in the thickness direction H of the main body can also be reduced.

Further, to ensure convenience of plugging or unplugging the USB cap, the first clamping portion 24 may be arranged at a central position of the first enclosure surface 28 along the thickness direction H of the main body.

FIG. 9 is a schematic structural diagram of the main body of a USB device according to an embodiment of the present invention. FIG. 10 is a schematic structural diagram of yet another USB cap of a USB device, and it does not fall within the scope of the present invention nor of its embodiments. Referring to FIG. 9 and FIG. 10, the USB device is based on the USB device shown in FIG. 5 and FIG. 6; first fitting portions 31 are further arranged on the first enclosure surface 28, and second fitting portions 32 that can tightly fit the first fitting portions 31 are arranged on the USB cap 22 correspondingly.

As shown in FIG. 9 and FIG. 10, one first fitting portion 31 is arranged respectively on both sides of the third surface and the fourth surface of the USB connector 29 on the first enclosure surface 28 along the width direction W of the main body; correspondingly, two second fitting portions 32 are arranged on the USB cap 22. However, the quantity of first fitting portions 31 and the position of the first fitting portion 31 on the first enclosure surface 28 are not limited in the present invention. For example, only one first fitting portion 31 is arranged at one side of the third surface of the USB connector 29 on the first enclosure surface 28 along the width direction W of the main body, or a first fitting portion 31 is arranged at one side of the first surface and/or the second surface of the USB connector 29 on the first enclosure surface 28 along the thickness direction H of the main body, and a second fitting portion 32 needs to be arranged correspondingly on the USB cap 22.

The first fitting portion 31 and the second fitting portion 32 that can tightly fit each other are arranged to ensure that when the USB cap 22 is fixed on the main body 21 through the first clamping portion 24 and the second clamping portion 25, the USB 22 is further positioned to avoid loosing the USB cap 22.

Further, the first fitting portions 31 are arranged on both sides on the first enclosure surface 28 which are vertical to a side on which the first clamping portion 24 is arranged, for example, if the first clamping portion 24 is arranged at a position close to the first surface of the USB connector 29, the first fitting portions 31 are arranged at both sides of the third surface and the fourth surface of the USB connector 29. In this way, through the first clamping portion 24 and the first fitting portion 31, the USB cap 22 may be positioned respectively in the thickness direction H of the main body and in the width direction W of the main body; the first clamping portion 24 and the first fitting portions 31 on both sides of the USB connector 29 form a triangular structure. According to the stability of the triangle, it can be further avoided that the USB cap 22 is loosened after it is fixed on the main body 21.

It should be noted that the first fitting portion 31 shown in FIG. 9 and FIG. 10 is a recess and the second fitting portion 32 is a protrusion. The first fitting portion 31 may also be set to a protrusion and the second fitting portion 32 may also be set to a recess, so long as the first fitting portion 31 and the second fitting portion 32 that are arranged correspondingly can tightly fit.

Further, a pattern draft may be arranged on the first fitting portion 31 and the second fitting portion 32 for mutual fitting, where the pattern draft for mutual fitting may provide a tension for the first fitting portion 31 and the second fitting portion 32 that tightly fit together, thereby further avoiding that the USB cap 22 is loosened after it is fixed on the main body 21.

In each of the foregoing implementations, structures of the first clamping portion and the second clamping portion may be any existing structure that can achieve a clamping function. Alternatively, the first clamping portion is a fixed card fastener arranged with a recess, and the second clamping portion is an elastic card fastener arranged with an elastic portion that fits the recess on the first clamping portion. In this way, in a process of fixing the USB cap on the main body, the elastic portion on the second clamping portion is deformed due to compression of the first clamping portion and is finally clamped into the recess on the first clamping portion, which can ensure that the USB cap is reliably fixed on the main body. When the USB cap needs to be pulled out, a position outside the USB cap and on the second clamping portion is pressed to deform the elastic portion on the second clamping portion. Therefore, the elastic portion can be pulled out from the recess on the first clamping portion, and then the USB cap can be pulled out from the main body.

## Claims

1. A USB device, comprising a main body (21) and a USB cap (22);
wherein a USB connector (23) is arranged at an end portion of the main body (21) along a length direction (L) of the main body (21) and a chamber (27) of the USB cap (22) is used to accommodate and protect the USB connector (23); **characterized in that** a first clamping portion (24) is arranged at one side of the USB connector (23) on a first enclosure surface (28) of the main body (21) that is oriented to the USB cap (22), and a second clamping portion (25) is arranged on the USB cap (22), wherein the first clamping portion (24) and the second clamping portion (25) are mutually clamped so that the USB cap (22) covers the USB connector (23) and is fixed on the main body (21), the first clamping portion is a fixed fastener arranged with a recess, and the second clamping portion is an elastic fastener arranged with an elastic portion that fits the recess on the first clamping portion; and
the first clamping portion (24) is arranged at a position on the first enclosure surface (28) along a thickness direction (H) of the main body (21) and adjacent to a first surface of the USB connector (23), the first surface is an upper surface at one side of the USB connector on which a metal fillet weld leg is deployed;
wherein a third clamping portion is arranged on the first enclosure surface (28), wherein the third clamping portion and the first clamping portion (24) are arranged at different sides of the USB connector; and
a fourth clamping portion is further arranged on the USB cap (22), wherein the third clamping portion and the fourth clamping portion are mutually clamped;
wherein the third clamping portion is arranged at a position on the first enclosure surface (28) and adjacent to a second surface of the USB connector (23);
wherein the second surface is a lower surface opposite to the first surface of the USB connector (23).

2. The device according to claim 1, wherein the first clamping portion (24) is arranged at a central position on the first enclosure surface (28) along a width direction (w) of the main body (21).

3. The device according to claim 1 or 2, wherein first fitting portions (31) are arranged on the first enclosure surface (28) and second fitting portions (32) that tightly fit the first fitting portions (31) are arranged on the USB cap (22) correspondingly.

4. The device according to claim 3, wherein the first fitting portions (31) are arranged at both sides of the USB connector (23) on the first enclosure surface (28) along a width direction (w) of the main body (21).

5. The device according to claim 1, wherein the first clamping portion (24) is arranged at one side of the USB connector (23) on the first enclosure surface (28) along a width direction (w) of the main body (21).

6. The device according to claims 3 or 4, wherein the first fitting portion is a protrusion and the second fitting portion is a recess; or the first fitting portion is a recess and the second fitting portion is a protrusion.

7. The device according to any one of claims 3, 4, and 6, wherein a pattern draft is arranged on the first fitting portion and the second fitting portion for mutual fitting.

8. The device according to any one of claims 1 to 7, wherein the first clamping portion (24) is a fixed card fastener arranged with a recess and the second clamping portion (25) is an elastic card fastener arranged with an elastic portion that fits the recess on the first clamping portion (24).

## Patentansprüche

1. USB-Vorrichtung, die einen Hauptkörper (21) und eine USB-Kappe (22) umfasst;
wobei ein USB-Verbindungselement (23) an einem Endabschnitt des Hauptkörpers (21) entlang einer Längenrichtung (L) des Hauptkörpers (21) angeordnet ist und eine Kammer (27) der USB-Kappe (22) verwendet wird, um das USB-Verbindungselement (23) aufzunehmen und zu schützen; **dadurch gekennzeichnet, dass** ein erster Klemmabschnitt (24) an einer Seite des USB-Verbindungselements (23) auf einer ersten Gehäuseoberfläche (28) des Hauptkörpers (21), der zu der USB-Kappe (22) orientiert ist, angeordnet ist, und ein zweiter Klemmabschnitt (25) auf der USB-Kappe (22) angeordnet ist, wobei der erste Klemmabschnitt (24) und der zweite Klemmabschnitt (25) wechselseitig geklemmt sind, so dass die USB-Kappe (22) das USB-Verbindungselement (23) bedeckt und auf dem Hauptkörper (21) befestigt ist, wobei der erste Klemmabschnitt ein festes Befestigungselement ist, das mit einer Aussparung angeordnet ist, und der zweite Klemmabschnitt ein elastisches Befestigungselement ist, das mit einem elastischen Abschnitt angeordnet ist, der zu der Aussparung des ersten Klemmabschnitts passt; und
der erste Klemmabschnitt (24) an einer Position auf der ersten Gehäuseoberfläche (28) in einer Dickenrichtung (H) des Hauptkörpers (21) und benachbart zu einer ersten Oberfläche des USB-Verbindungselements (23) angeordnet ist, wobei die erste Oberfläche eine Oberseite an einer Seite des USB-Verbindungselements ist, auf der ein Schenkel einer Metallkehlnaht eingesetzt ist;
wobei ein dritter Klemmabschnitt auf der ersten Gehäuseoberfläche (28) angeordnet ist, wobei der dritte Klemmabschnitt und der erste Klemmabschnitt (24) an unterschiedlichen Seiten des USB-Verbindungselements angeordnet sind; und
eine vierter Klemmabschnitt ferner auf der USB-Kappe (22) angeordnet ist, wobei der dritte Klemmabschnitt und der vierte Klemmabschnitt wechselseitig geklemmt sind;
wobei der dritte Klemmabschnitt an einer Position auf der ersten Gehäuseoberfläche (28) und benachbart einer zweiten Oberfläche des USB-Verbindungselements (23) angeordnet ist;
wobei die zweite Oberfläche eine Unterseite gegenüber der ersten Oberfläche des USB-Verbindungselements (23) ist.

2. Vorrichtung nach Anspruch 1, wobei der erste Klemmabschnitt (24) an einer zentralen Position auf der ersten Gehäuseoberfläche (28) entlang einer Breitenrichtung (w) des Hauptkörpers (21) angeordnet ist.

3. Vorrichtung nach Anspruch 1 oder 2, wobei erste Passabschnitte (31) auf der ersten Gehäuseoberfläche (28) angeordnet sind und zweite Passabschnitte (32), die fest auf die ersten Passabschnitte (31) passen, auf der USB-Kappe (22) entsprechend angeordnet sind.

4. Vorrichtung nach Anspruch 3, wobei die ersten Passabschnitte (31) auf beiden Seiten des USB-Verbindungselements (23) auf der ersten Gehäuseoberfläche (28) entlang einer Breitenrichtung (w) des Hauptkörpers (21) angeordnet sind.

5. Vorrichtung nach Anspruch 1, wobei der erste Klemmabschnitt (24) auf einer Seite des USB-Verbindungselements (23) auf der ersten Gehäuseoberfläche (28) entlang einer Breitenrichtung (w) des Hauptkörpers (21) angeordnet ist.

6. Vorrichtung nach Anspruch 3 oder 4, wobei der erste Passabschnitt ein Vorsprung ist und der zweite Passabschnitt eine Aussparung ist; oder der erste Passabschnitt eine Aussparung ist und der zweite Passabschnitt ein Vorsprung ist.

7. Vorrichtung nach einem der Ansprüche 3, 4 und 6, wobei eine strukturelle Schräge auf dem ersten Passabschnitt und dem zweiten Passabschnitt zum wechselseitigen Passen angeordnet ist.

8. Vorrichtung nach einem der Ansprüche 1 bis 7, wobei der erste Klemmabschnitt (24) ein festes Kartenbefestigungselement ist, das mit einer Aussparung angeordnet ist, und der zweite Klemmabschnitt (25) ein elastisches Kartenbefestigungselement ist, das mit einem elastischen Abschnitt angeordnet ist, der zu der Aussparung auf dem ersten Klemmabschnitt (24) passt.

## Revendications

1. Dispositif USB, comprenant un corps principal (21) et un capuchon USB (22);
dans lequel un connecteur USB (23) est agencé au niveau d'une partie d'extrémité du corps principal (21) le long du sens de la longueur (L) du corps principal (21) et une chambre (27) du capuchon USB (22) est utilisée pour recevoir et protéger le connecteur USB (23);
**caractérisé en ce qu'**une première partie de serrage (24) est agencée sur un côté du connecteur USB (23) sur une première surface de fermeture (28) du corps principal (21) qui est orientée vers le capuchon USB (22), et une deuxième partie de serrage (25) est agencée sur le capuchon USB (22), dans lequel la première partie de serrage (24) et la deuxième partie de serrage (25) sont serrées mutuellement de telle sorte que le capuchon USB (22) couvre le connecteur USB (23) et soit fixé sur le corps principal (21), la première partie de serrage étant un élément de fixation fixe comprenant un évidement, et la deuxième partie de serrage étant un élément de fixation élastique comprenant une partie élastique qui s'agence dans l'évidement sur
la première partie de serrage; et
la première partie de serrage (24) est agencée à une position sur la première surface de fermeture (28) le long du sens de l'épaisseur (H) du corps principal (21) et à proximité d'une première surface du connecteur USB (23), la première surface étant une surface supérieure d'un côté du connecteur USB sur lequel un côté de cordon de soudure métallique est déployé;
dans lequel une troisième partie de serrage est en outre agencée sur la première surface de fermeture (28),
dans lequel la troisième partie de serrage et la première partie de serrage (24) sont agencées sur des côtés différents du connecteur USB; et
une quatrième partie de serrage est en outre agencée sur le capuchon USB (22), dans lequel la troisième partie de serrage et la quatrième partie de serrage sont serrées mutuellement;
dans lequel la troisième partie de serrage est agencée à une position sur la première surface de fermeture (28) et à proximité d'une seconde surface du connecteur USB (23);
dans lequel la seconde surface est une surface inférieure opposée à la première surface du connecteur USB (23).

2. Dispositif selon la revendication 1, dans lequel la première partie de serrage (24) est agencée à une position centrale sur la première surface de fermeture (28) le long du sens de la largeur (w) du corps principal (21).

3. Dispositif selon la revendication 1 ou 2, dans lequel des premières parties de raccord (31) sont agencées sur la première surface de fermeture (28) et des secondes parties de raccord (32) qui s'agencent étroitement dans les premières parties de raccord (31) sont agencées sur le capuchon USB (22) de façon correspondante.

4. Dispositif selon la revendication 3, dans lequel les premières parties de raccord (31) sont agencées sur les deux côtés du connecteur USB (23) sur la première surface de fermeture (28) le long du sens de la largeur (w) du corps principal (21).

5. Dispositif selon la revendication 1, dans lequel la première partie de serrage (24) est agencée sur un côté du connecteur USB (23) sur la première surface de fermeture (28) le long du sens de la largeur (w) du corps principal (21).

6. Dispositif selon la revendication 3 ou 4, dans lequel la première partie de raccord est une saillie et la seconde partie de raccord est un évidement; ou la première partie de raccord est un évidement et la seconde partie de raccord est une saillie.

7. Dispositif selon l'une quelconque des revendications 3, 4 et 6, dans lequel une ébauche de motif est formée sur la première partie de raccord et sur la seconde partie de raccord en vue d'un raccord mutuel.

8. Dispositif selon l'une quelconque des revendications 1 à 7, dans lequel la première partie de serrage (24) est un élément de fixation de carte fixe comprenant un évidement, et la deuxième partie de serrage (25) est un élément de fixation de carte élastique comprenant une partie élastique qui s'agence dans l'évidement sur la première partie de serrage (24).
